# EUROPEAN PATENT SPECIFICATION

(11) **EP 1 211 715 B1**
(45) Date of publication and mention of the grant of the patent: **15.01.2014**
(21) Application number: 01126945.3
(22) Date of filing: 13.11.2001
(51) Int. Cl.: H01L 21/20, C30B 25/18, C23C 16/30, C23C 16/02

(54) **A method for fabricating a III-V nitride film**
Verfahren zur Herstellung eines III-V-Nitridfilms
Procédé de fabrication d'une couche en nitrure III-V

(30) Priority: 21.11.2000 JP 2000353941; 12.10.2001 JP 2001314662
(43) Date of publication of application: 05.06.2002
(73) Proprietor: NGK Insulators, Ltd., Nagoya City, Aichi Pref. (JP)
(72) Inventor: Asai, Keiichiro, c/o NGK Insulators, Ltd., Nagoya City,Aichi Pref. (JP); Shibata, Tomohiko, c/o NGK Insulators, Ltd., Nagoya City,Aichi Pref. (JP); Nakamura, Yukinori, c/o NGK Insulators, Ltd., Nagoya City,Aichi Pref. (JP); Tanaka, Mitsuhiro, c/o NGK Insulators, Ltd., Nagoya City,Aichi Pref. (JP)
(74) Representative: TBK

(56) References cited:
- EP-A1- 0 817 283
- EP-A2- 0 993 048
- WO-A-00/33364
- JP-A- 11 274 561
- WEEKS T W ET AL: "GAN THIN FILMS DEPOSITED VIA ORGANOMETALLIC VAPOR PHASE EPITAXY ON ALPHA(6H)-SIC(0001) USING HIGH-TEMPERATURE MONOCRYSTALLINE AIN BUFFER LAYERS" APPLIED PHYSICS LETTERS, AIP, AMERICAN INSTITUTE OF PHYSICS, MELVILLE, NY, US, vol. 67, no. 3, 17 July 1995 (1995-07-17), pages 401-403, XP000522092 ISSN: 0003-6951
- LAHRECHE H ET AL: "Optimisation of AlN and GaN growth by metalorganic vapour-phase epitaxy (MOVPE) on Si (111)" JOURNAL OF CRYSTAL GROWTH, ELSEVIER, AMSTERDAM, NL, vol. 217, no. 1-2, July 2000 (2000-07), pages 13-25, XP004208021 ISSN: 0022-0248
- ISHIKAWA H ET AL: "HIGH-QUALITY GAN ON SI SUBSTRATE USING ALGAN/ALN INTERMEDIATE LAYER" PHYSICA STATUS SOLIDI (A). APPLIED RESEARCH, BERLIN, DE, vol. 176, no. 1, 16 November 1999 (1999-11-16), pages 599-603, XP008026606 ISSN: 0031-8965
- STRITTMATTER A ET AL: "EPITAXIAL GROWTH OF GAN ON SILICON SUBSTRATES BY LOW-PRESSURE MOCVD USING ALAS, ALAS/GAAS, AND ALN BUFFER LAYERS" MATERIALS SCIENCE FORUM, AEDERMANNSFDORF, CH, vol. 264-268, no. PART 2, 1998, pages 1145-1148, XP000856837 ISSN: 0255-5476

## Description

### Background of the invention

### (1) Field of the invention:

This invention relates to a method for fabricating a III nitride film, an underlayer for fabricating a III nitride film and a method for fabricating the same underlayer, particularly usable for semiconductor films constituting a light-emitting diode or a high velocity IC chip. (2) Related Art Statement:

III nitride films are employed as semiconductor films constituting a light-emitting diode, and recently, win a lot of attention as semiconductor films constituting high velocity IC chips to be used in cellular phones.

Such III nitride films are usually fabricated by MOCVD methods. Concretely, a substrate on which III nitride films are formed is set onto a susceptor installed in a given reactor, and then, heated to 1000°C or over with a heater provided in or out of the susceptor. Thereafter, raw material gases are introduced with a carrier gas into the reactor and supplied onto the substrate.

On the substrate, the raw material gases are dissolved through thermochemical reaction into constituent elements, which are reacted to deposit and fabricate a desired III nitride film on the substrate.

There are few suitable substrates, which have nearly equal lattice constants and thermal expansion coefficients to those of III nitride films. In this case, the difference in the lattice constants between the III nitride film and the substrate may induce more misfit dislocations at the boundary between the III nitride film and the substrate. In order to reduce such misfit dislocations, generally, a lower crystallinity buffer layer, which is fabricated at a lower temperature, is provided between the substrate and the III nitride film. In this case, the difference in lattice constant is compensated, and thus, much misfit dislocations are not created.

However, the misfit dislocations are not reduced sufficiently even though the buffer layer is provided, so that much dislocation of about 10⁹-10¹⁰/cm² may be created in the III nitride film originated from the propagation of the misfit dislocations. As a result, the crystal quality of the III nitride film is degraded, and thus, the electrical and optical properties of the III nitride film are degraded.

In order to iron out the above problem, such an attempt is made as to form a patterned mask made of SiO₂ on the substrate and epitaxially grow the III nitride film laterally on the substrate. In this case, misfit dislocations are propagated laterally on the mask, and not propagated vertically. Therefore, the dislocation density of the III nitride film can be lowered in the region above the patterned mask.

However, since a photolithography process including an etching step is required in forming the patterned mask, the total steps of the fabricating process for the III nitride film are increased and complicated.

EP0 817 283 A1 disclosed a method of fabricating a Group III-nitride film by using an underfilm of AlN of unspecified surface roughness. phys. stat. sol. (a), 176, 599 (1999) discloses an underfilm consisting of two sublayers, the first one being formed of AlN is grown at 1100°C, and the second one of AlₓGa₁₋ₓN with x=0.27 is grown at 1080°C.

### Summary of the Invention

It is an object of the present invention to provide a method able to easily fabricate a III nitride film of lower dislocation density.

In order to achieve the above object, this invention relates to A method for fabricating a III nitride film, including steps of preparing a given substrate, forming an underfilm having its surface of concave-convex structure in which 50% or below is occupied by a flat region having an average roughness of 10Å or below and made of a first III nitride including 50 atomic percentages or over of Al element for all of the III elements constituting the first III nitride, and forming a III nitride film on the underfilm.

The inventors had intensely studied to obtain a III nitride film of lower dislocation density through an easy fabricating process without a patterned mask made of SiO₂. As a result, they found out that such an underfilm as mentioned above is formed on a substrate, thus, a given III nitride film is formed on the underfilm by a MOCVD method, to reduce the dislocation density of the III nitride film.

Such an underfilm can be made as follows. First of all, a V raw material gas and a III raw material gas are supplied onto a substrate at a flow ratio (V raw material gas/III raw material gas) of 600 or below, to form, on the substrate, a first film made of a III nitride including 50 atomic percentages or over of Al element for all of the III elements through the epitaxial growth for a given period. Then, the raw material gas and the III material gas are supplied onto the substrate at flow ratio (V raw material gas/III raw material gas) of more than 600, to form, on the first film, a second film made of another III nitride including 50 atomic percentages or over of Al element for all of the III elements through the epitaxial growth for a given period.

Moreover, a V raw material gas and a III raw material gas are supplied onto the substrate under a pressure of 27hPa (20 Torr) or below, to form, on the substrate, a first film made of a III nitride including 50 atomic percentages or over of A1 element for all of the III element through the epitaxial growth for a given period. Then, the raw material gas and the III material gas are supplied onto the substrate under a pressure of more than 27hPa (20 Torr), to form, on the first film, a second film made of another III nitride including 50 atomic percentages or over of Al element for all of the III elements through the epitaxial growth for a given period.

Furthermore, a V raw material gas and a III raw material gas are supplied onto the substrate heated at 1100°C or over, to form, on the substrate, a first film made of a III nitride including 50 atomic percentages or over of Al element for all of the III elements through the epitaxial growth for a given period. Then, the raw material gas and the III material gas are supplied onto the substrate heated at less than 1100°C, to form, on the first film, a second film made of another III nitride including 50 atomic percentages or over of Al element for all of the III elements through the epitaxial growth for a given period.

That is, the above-mentioned underfilm is stepwisely formed by using respective two fabricating conditions of MOCVD. In this case, the crystallinity of the underfilm is developed and a concave-convex structure is formed on the underfilm. If Al element of 50 atomic percentages or over for all of the III elements incorporated into the underfilm, the concave-convex structure can be easily formed. Therefore, without using a complicated photolithography process, the underfilm can be easily formed in the same apparatus as that of the III nitride film.

Therefore, the III nitride film of lower dislocation density and good crystallinity can be fabricated without complicating the fabricating process.

Herein, the first through the third fabricating method may be employed in isolation or combination of two or over. Moreover, another fabricating method may be employed. For example, if the flow ratio of (V raw material gas/III raw material gas) is set to 1000 or over, the underfilm can be formed at one step by using one fabricating condition of MOCVD.

### Brief Description of the Drawings

For better understanding of the present invention, reference is made to the attached drawings, wherein
Fig. 1 is a SEM photograph showing the surface figuration of an AIN underfilm fabricated according to the present invention,
Fig. 2 is a SEM photograph showing the surface figuration of another AIN underfilm fabricated according to the present invention,
Fig. 3 is a SEM photograph showing the surface figuration of still another AlN underfilm fabricated according to the present invention,
Fig. 4 is a SEM photograph showing the surface figuration of a further AlN underfilm, and
Fig. 5 is a SEM photograph showing the surface figuration of a still further AIN underfilm.

### Description of the Preferred Embodiments

This invention will be described in detail, hereinafter.

In the fabricating method of a III nitride film according to the present invention, it is required that a first III nitride to constitute an underfilm includes 50 atomic percent or over, preferably 70 atomic percent or over of Al element for all of the III elements of the first III nitride. Particularly, the first III nitride is preferably made of AlN. In this case, the dislocation density of the III nitride film to be formed on the underfilm can be reduced effectively, and thus, the crystal quality of the III nitride film can be enhanced.

The first III nitride may include an additive element such as Ge, Si, Mg, Zn, Be, P or B as occasion demands. Moreover, the first III nitride may include a minute impurity contained in the raw material gases and the reactor or contained dependent on the forming condition.

Moreover, it is required that the flat region in the surface of the underfilm is set to 50% or below, preferably 10% or below. Herein, the wording "flat region" means an average roughness Ra of 10Å or below. Particularly, it is desired that no flat region is formed in the surface of the underfilm, and thus, a concave-convex structure is formed over the surface of the underfilm entirely.

In this case, the dislocation density of the III nitride film to be formed on the underfilm can be reduced effectively.

For the same reason as mentioned above, it is desired that the concave-convex structure except the flat region includes {101} facets.

As a result, the dislocation density of the III nitride film is reduced and thus improved to about 10⁶-10⁷, which is on the order of 1/10²-1/10³ as compared with the one of a conventional III nitride film.

The underfilm may be fabricated by two fabricating steps as follows.

First of all, a V raw material gas and a III raw material gas containing the constituent elements of the first III nitride of the underfilm are introduced into a reactor so that the flow ratio of (V raw material gas/III raw material gas) is set to 600 or below, preferably 450 or below and the pressure inside the reactor is set to 27hPa (20 Torr) or below, preferably 20hPa (15 Torr) or below, and then, supplied onto a substrate heated at 1100°C or over, preferably 1150°C or over, to form a first film made of a III nitride including 50 atomic percent or over of Al element for all of the III elements through the epitaxial growth for a given period.

Herein, it is not necessary that all of the flow rate condition, the pressure condition and the substrate temperature condition are satisfied, but it is necessary that at least one of these conditions is satisfied.

Thereafter, on the condition that the above-mentioned pressure condition and the above-mentioned substrate temperature condition are satisfied, the flow ratio of (V raw material gas/III raw material gas) is set to 600 or over, preferably 1000 or over, to form, on the first III nitride film, a second film made of another III nitride including 50 atomic percent or over of Al element for all of the III elements. In this way, a concave-convex structure is formed in the surface of the thus obtained underfilm made of the first and the second nitride films.

In forming the second III nitride film, the pressure condition instead of the flow ratio condition may be varied, to form the underfilm having a concave-convex structure. Concretely, on the condition that the above-mentioned flow ratio condition and the above-mentioned substrate temperature condition are satisfied, the interior pressure of the reactor is set to 27hPa (20 Torr) or over, preferably 53hPa (40 Torr) or over.

Moreover, in forming the second III nitride film, the substrate temperature condition instead of the flow rate condition and the pressure condition may be varied, to form the underfilm having a concave-convex structure. Concretely, on the condition that the above-mentioned flow rate condition and the pressure condition are satisfied, the substrate temperature is set to 1100°C or over, preferably 900°C or below, more preferably within a range of 950-1050°C. Herein, the substrate temperature means a "setting temperature for the substrate".

The upper limit value and lower limit value not specified may be determined appropriately dependent on the composition of the underfilm and the film-forming rate.

The substrate may be made of oxide single crystal such as sapphire single crystal, ZnO single crystal, LiAlO₂ single crystal, LiGaO₂ single crystal, MgAl₂O₄ single crystal, or MgO single crystal, IV single crystal or IV-IV single crystal such as Si single crystal or SiC single crystal, III-V single crystal such as GaAs single crystal, AlN single crystal, GaN single crystal or AlGaN single crystal, and boride single crystal such as ZrB₂.

Particularly, in the case of making the substrate of the sapphire single crystal, it is desired that surface-nitriding treatment is performed on the main surface of the substrate for the underlayer to be formed. The surface-nitriding treatment is performed as follows. First of all, the sapphire single crystal substrate is set in a nitrogen-including atmosphere such as an ammonia atmosphere, and then, heated for a given period. The thickness of the resulting surface nitride layer can be adjusted by controlling the nitrogen concentration, the nitriding temperature and the nitriding period appropriately.

If the sapphire single crystal substrate having the surface nitriding layer thereon is employed, the crystal quality of the underlayer formed directly on the main surface can be more developed. As a result, the crystal quality of the III nitride film to be formed on the underlayer can be developed, and thus, the dislocation density of the III nitride film can be more reduced.

It is desired that the surface-nitriding layer is formed thicker, for example, so that the nitrogen content of the sapphire single crystal substrate at the depth of 1nm from the main surface is set to five atomic percent or over, in ESCA analysis.

In view of enhancing the crystal quality of the underfilm, it is desired that the underfilm is formed at a higher temperature of 1100°C or over and preferably 1250°C or below.

Moreover, an epitaxial substrate composed of a given base material and a high crystallinity surface layer made of a second III nitride having a full width at half maximum (FWHM) of 90 seconds or below in X-ray rocking curve may be used.

Using such a substrate as mentioned above and such a fabricating method as according to the present invention, the underfilm to satisfy the conditions required according to the present invention as mentioned above can be fabricated easily and precisely. As a result, the III nitride film of lower dislocation density can be fabricated easily at good yield ratio.

In the present invention, the III nitride film to be formed on the underfilm has preferably the composition of AlxGayInzN (x+y+z=1), and, may include an additive element such as Ge, Si, Mg, Zn, Be, P or B as occasion demands. Moreover, the III nitride film may include a minute impurity contained in the raw material gases and the reactor or contained dependent on the forming condition.

### Examples:

This invention will be concretely described, hereinafter.

### (Example 1)

A C-faced sapphire single crystal substrate was employed, and then, set on a susceptor installed in a reactor of a MOCVD apparatus, and heated to 1200°C with a heater built in the susceptor.

First of all, an ammonia gas (NH₃) was flown with a hydrogen (H₂) carrier gas for five minutes, to nitride the main surface of the substrate. In ESCA analysis, it turned out that a surface-nitriding layer was formed on the main surface by the surface-nitriding treatment, and the nitrogen content at the depth of 1nm from the main surface was seven atomic percentages.

Then, a trimethyl aluminum (TMA), a trimethyl gallium (TMG) and a trimethyl indium (TMI) were employed as Al raw material, Ga raw material and In raw material, respectively. Moreover, an ammonia gas was employed as nitrogen raw material. These raw material gases were introduced with a H₂ carrier gas into the reactor at a flow ratio of NH₃/TMA=450 under a pressure of 20hPa (15 Torr), and supplied onto the substrate, to form an AlN film as a first III nitride film through epitaxial growth for 60 minutes. Thereafter, changing the flow ratio to 1000 from 450, another AlN film was formed as a second III nitride film, to form an AlN underfilm having a thickness of 1.5µm.

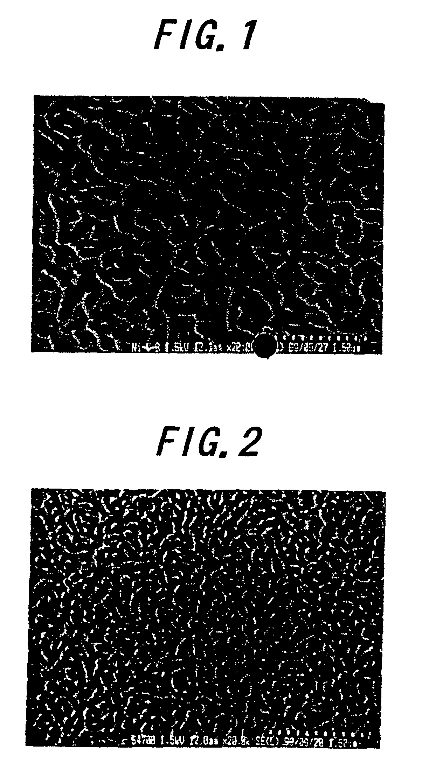

Fig. 1 is a SEM photograph showing the surface figuration of the AlN underfilm. In Fig. 1, the flat region in the surface of the AlN underfilm is designated by the white region, and the concave-convex structure is designated by the black region. As is apparent from Fig. 1, about 50% of the surface of the AlN film is occupied by the flat region. When the surface roughness of the flat region was observed with a AFM, it turned out that the average roughness Ra of the flat region was 5Å.

When the FWHM in X-ray rocking curve of the (002) plane of the AlN underfilm was examined, it was 80 seconds.

Then, the substrate was heated at 1050°C with the heater built in the susceptor, and then, a TMG as Ga raw material and an ammonia gas as nitrogen raw material were introduced with a H₂ and N₂ carrier gas into the reactor at a flow ratio of NH₃/TMG=5000, and supplied onto the substrate, to form a GaN film having a thickness of 3µm.

When the dislocation density of the GaN film was observed with a transmission electron microscope (TEM), it was about 1×10⁷/cm².

In forming the second AlN film, if the substrate temperature may be changed to 1080°C from 1200°C or the raw material pressure inside the reactor may be changed to 40hPa (30 Torr) from 20hPa (15 Torr), instead of changing the flow ratio, such an underfilm as having almost 50% flat region ratio can be fabricated and thus, such a GaN film as having a lower dislocation density of about 1×10⁷/cm² can be obtained.

### (Example 2)

Except that the TMA and the NH₃ were supplied onto the substrate heated at 1200°C, made of C-faced sapphire crystal, at a flow ratio of NH₃/TMA=1000 under a pressure of 20hPa (15 Torr), to form an AIN underfilm having a thickness of 0.7µm through the epitaxial growth for 60 minutes at one step, a GaN film was formed in a thickness of 3µm on the AlN underfilm in the same manner as Example 1.

It was confirmed that a concave-convex structure was formed in the surface of the AlN underfilm, as shown in Fig. 1, and the surface roughness (average roughness Ra) of the flat region in the surface of the AlN underfilm was about 5Å. Also, about 50% of the surface of the AIN film was occupied by the flat region. When the FWHM in X-ray rocking curve of the (002) plane of the AIN underfilm was examined, it was 80 seconds. The dislocation density of the GaN film was about 1×10⁷/cm².

### (Example 3)

Except that, in forming the second AlN film, the flow ratio NH₃/TMA was changed to 1500 from 1000, an AlN underfilm was formed in the same manner as Example 1.

Fig. 2 is a SEM photograph showing the surface figuration of the AlN underfilm. As is apparent from Fig. 2, about 20% of the surface of the AlN underfilm was occupied by the flat region. The FWHM in X-ray rocking curve of the (002) plane of the AlN underfilm was 80 seconds.

Then, a GaN film was formed in a thickness of 3µm on the AlN underfilm in the same manner as Example 1. The dislocation density of the GaN film turned out to be about 5×10⁶/cm² through the TEM observation.

### (Example 4)

Except that, in forming the second AlN film, the flow ratio NH₃/TMA was changed to 2000 from 1000, an AIN underfilm was formed in the same manner as Example 1.

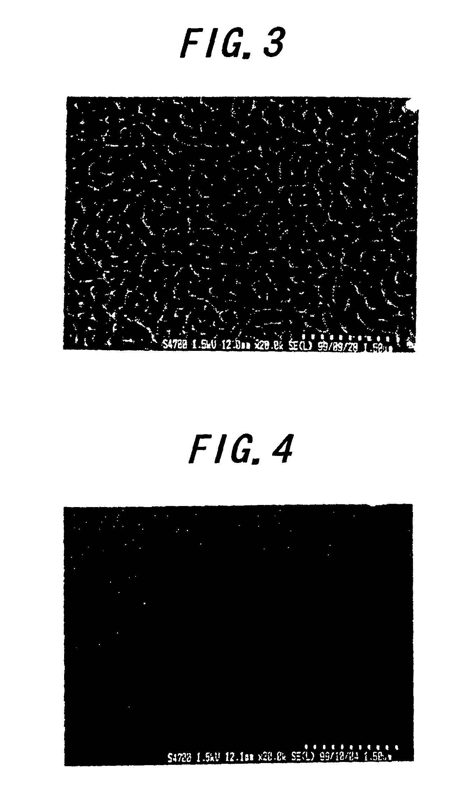

Fig. 3 is a SEM photograph showing the surface figuration of the AIN underfilm. As is apparent from Fig. 3, none of the surface of the AlN underfilm was almost occupied by the flat region, and thus, a concave-convex structure was formed over the AlN underfilm entirely.

Then, a GaN film was formed in a thickness of 3µm on the AIN underfilm in the same manner as Example 1. The dislocation density of the Ga film turned out to be about 1×10⁶/cm² through the TEM observation.

In forming the second AlN film, if the substrate temperature may be changed to 1040°C from 1200°C or the raw material pressure inside the reactor may be change to 60hPa (45 Torr) from 20hPa (15 Torr), instead of changing the flow ratio, such an underfilm as having the almost 0% flat region ratio can be fabricated and thus, such a GaN film as having a lower dislocation density of about 1×10⁶/cm² can be obtained.

### (Comparative Example 1)

The TMA and NH₃ were supplied onto a C-faced sapphire substrate heated at 1200°C at a flow ratio of NH₃/TMA=450 under a pressure of 20 hPa (15 Torr), to form an AlN underfilm having a thickness of 1µm at one step.

Fig. 4 is a SEM photograph showing the surface figuration of the AlN underfilm. As is apparent from Fig. 4, all of the surface of the AlN underfilm was occupied by the flat region.

Then, a GaN film was formed on the AlN underfilm in the same manner as Examples. The dislocation density of the AIN underfilm was about 1×10⁸/cm².

### (Comparative Example 2)

The TMA and NH₃ were supplied onto a C-faced sapphire substrate heated at 1200°C at a flow ratio of NH₃/TMA=700 under a pressure of 20 hPa (15 Torr), to form an AlN underfilm having a thickness of 1µm at one step.

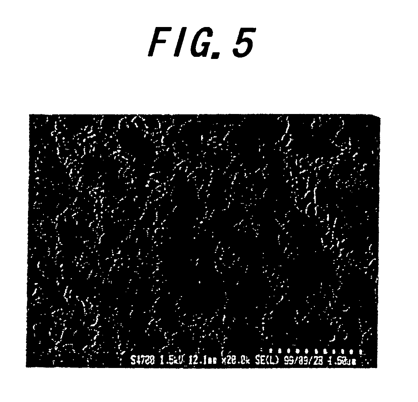

Fig. 5 is a SEM photograph showing the surface figuration of the AlN underfilm. As is apparent from Fig. 5, most of the surface, that is, about 70% of the surface of the AlN underfilm was occupied by the flat region.

Then, a GaN film was formed on the AlN underfilm in the same manner as Examples. The dislocation density of the GaN film turned out to be about 8×10⁷/cm².

As is apparent from Examples and Comparative Examples, if an AlN underfilm is formed according to the present invention and a GaN film as a III nitride film is formed on the AlN underfilm, the dislocation density of the GaN film can be reduced to an order of 10⁷/cm².

For example, in forming the second AIN film in Examples, only if the flow ratio NH₃/TMA is set within the range required according to the present invention, it may be changed during the formation of the second AIN film constituting the AlN underfilm. Instead of the GaN film, an AlGaInN film or an AlN film may be formed on the AlN underfilm. Moreover, although the AIN underfilm and the GaN film are formed in the same MOCVD apparatus, they may be done in their respective appropriate MOCVD apparatuses.

For developing the crystal qualities of an underfilm made of e.g., AlN and a III nitride film made of e.g., GaN, a buffer layer or a multi-layered stacking films constituting, e.g., a distorted superlattice structure may be provided between a substrate and the underfilm or between the underfilm and the III nitride film.

As explained above, if an underfilm is formed on a given substrate by a simple MOCVD method according to the present invention, and then, a desired III nitride film is formed on the underfilm, the dislocation density of the III nitride film can be reduced remarkably.

On a given substrate is formed an underfilm including a surface of concave-convex structure in which 50% or over is occupied by a flat region having an average roughness of 10 Å or below and made of a III nitride including 50 atomic percent or over of A1 element for all of the III elements constituting the III nitride. Then, a desired III nitride film is formed on the underfilm by a normal MOCVD method.

## Claims

1. A method for fabricating a III nitride film, comprising the steps of:
preparing a given substrate,
forming an underfilm having its surface of concave-convex structure in which 50% or below is occupied by a flat region having an average roughness Ra of 10 Å or below and made of a first III nitride including 50 atomic percent or over of Al element for all of the III elements constituting the first III nitride, and
forming a III nitride film on the underfilm.

2. A fabricating method as defined in claim 1, wherein the first III nitride constituting the underfilm includes 70 atomic percent or over of Al element for all of the III elements constituting the first III nitride.

3. A fabricating method as defined in claim 2, wherein the first III nitride constituting the underfilm is AIN.

4. A fabricating method as defined in any one of claims 1-3, wherein 10% of the surface of the underfilm is occupied by the flat region.

5. A fabricating method as defined in any one of claims 1-4, wherein the concave-convex structure except the flat region of the surface of the underfilm includes {101} facets.

6. A fabricating method as defined in any one of claims 1-5, wherein the substrate is made of sapphire single crystal or SiC single crystal.

7. A fabricating method as defined in claim 6, wherein a surface nitriding treatment is performed onto the main surface of the sapphire single crystal substrate to form a nitrided surface layer at the main surface, and the underfilm is formed on the sapphire single crystal substrate via the nitrided surface layer.

8. A fabricating method as defined in any one of claims 1-7, further comprising the step of forming, on the substrate, a surface layer having an average roughness Ra of 10 Å or below, and made of a second III nitride having a full width at half maximum in X-ray rocking curve of 90 seconds or below and including 50 atomic percent or over of Al element for all of the III elements constituting the second III nitride.

9. A fabricating method as defined in any one of claims 1-8, wherein the step of forming the underfilm comprises the steps of:
preparing a substrate,
supplying a V raw material gas and a III raw material gas onto the substrate at a flow ratio (V raw material gas/III raw material gas) of 600 or below, to form, on the substrate, a first film made of a III nitride including 50 atomic percent or over of Al element for all of the III elements through the epitaxial growth for a given period, and
supplying the V raw material gas and the III material gas onto the substrate at flow ratio (V raw material gas/III raw material gas) of more than 600, to form, on the first film, a second film made of another III nitride including 50 atomic percent or over of Al element for all of the III elements through the epitaxial growth for a given period.

10. A fabricating method as defined in any one of claims 1-8, wherein the step of forming the underfilm comprises the steps of:
preparing a substrate,
supplying a V raw material gas and a III raw material gas onto the substrate under a pressure of 27hPa (20 Torr) or below, to form, on the substrate, a first film made of a III nitride including 50 atomic percent or over of Al element for all of the III element through the epitaxial growth for a given period, and
supplying the V raw material gas and the III material gas onto the substrate under a pressure of more than 27 hPa (20 Torr), to form, on the first film, a second film made of another III nitride including 50 atomic percent or over of Al element for all of the III elements through the epitaxial growth for a given period.

11. A fabricating method as defined in any one of claims 1-8, wherein the step of forming the underfilm comprises the steps of:
preparing a substrate,
supplying a V raw material gas and a III raw material gas onto the substrate heated at 1100 °C or over, to form, on the substrate, a first film made of a III nitride including 50 atomic percent or over of Al element for all of the III elements through the epitaxial growth for a given period, and
supplying the V raw material gas and the III material gas onto the substrate heated at less than 1100 °C, to form, on the first film, a second film made of another III nitride including 50 atomic percent or over of A1 element for all of the III elements through the epitaxial growth for a given period.

## Patentansprüche

1. Verfahren zum Herstellen eines III-Nitridfilms, das die Schritte umfasst:
Vorbereiten eines gegebenen Substrats,
Bilden eines Unterfilms mit dessen Oberfläche von konkavkonvexer Struktur, bei welcher 50% oder weniger von einem flachen Bereich mit einer durchschnittlichen Rauheit Ra von 10 Å oder darunter eingenommen ist, und der aus einem ersten III-Nitrid, das 50 Atomprozent oder darüber an Al-Element für alle der III Elemente, die das erste III-Nitrid aufbauen, beinhaltet, hergestellt ist, und
Bilden eines III-Nitridfilms aus dem Unterfilm.

2. Herstellungsverfahren nach Anspruch 1, wobei das erste III-Nitrid, das den Unterfilm aufbaut, 70 Atomprozent oder darüber an Al-Element für alle der III Elemente, die das erste III-Nitrid aufbauen, beinhaltet.

3. Herstellungsverfahren nach Anspruch 2, wobei das erste III-Nitrid, das den Unterfilm aufbaut, AlN ist.

4. Herstellungsverfahren nach einem der Ansprüche 1-3, wobei 10% der Oberfläche des Unterfilms von dem flachen Bereich eingenommen sind.

5. Herstellungsverfahren nach einem der Ansprüche 1-4, wobei die konkav-konvexe Struktur mit Ausnahme des flachen Bereichs der Oberfläche des Unterfilms {101}-Facetten beinhaltet.

6. Herstellungsverfahren nach einem der Ansprüche 1-5, wobei das Substrat aus einem Saphireinkristall oder einem SiC-Einkristall hergestellt ist.

7. Herstellungsverfahren nach Anspruch 6, wobei eine Oberflächennitrierungsbehandlung auf die Hauptoberfläche des Saphireinkristallsubstrats durchgeführt wird, um eine nitrierte Oberflächenschicht an der Hauptoberfläche zu bilden, und der Unterfilm auf dem Saphireinkristallsubstrat mittels der nitrierten Oberflächenschicht gebildet wird.

8. Herstellungsverfahren nach einem der Ansprüche 1-7, ferner umfassend den Schritt des Bildens, auf dem Substrat, einer Oberflächenschicht mit einer durchschnittlichen Rauheit Ra von 10 Å oder darunter, und die aus einem zweiten III-Nitrid mit einer Halbwertsbreite bei der Röntgen-Rocking-Curve von 90 Sekunden oder darunter und das 50 Atomprozent oder darüber an Al-Element für alle der III Elemente, die das zweite III-Nitrid aufbauen, beinhaltet, hergestellt ist, umfasst.

9. Herstellungsverfahren nach einem der Ansprüche 1-8, wobei der Schritt des Bildens des Unterfilms die Schritte umfasst:
Vorbereiten eines Substrats,
Zuführen eines V-Rohmaterialgases und eines III-Rohmaterialsgases auf das Substrat bei einem Strömungsverhältnis (V-Rohmaterialgas/ III-Rohmaterialgas) von 600 oder darunter, um auf dem Substrat einen ersten Film, der aus einem III-Nitrid hergestellt ist, das 50 Atomprozent oder darüber an Al-Element für alle der III Elemente beinhaltet, durch das epitaxiale Wachstum für einen vorgegebenen Zeitraum zu bilden, und
Zuführen des V-Rohmaterialgases und des III-Rohmaterialgases auf das Substrat bei einem Strömungsverhältnis (V-Rohmaterialgas/ III-Rohmaterialgas) von mehr als 600, um auf dem ersten Film einen zweiten Film, der aus einem weiteren III-Nitrid hergestellt ist, das 50 Atomprozent oder darüber an Al-Element für alle der III Elemente beinhaltet, durch das epitaxiale Wachstum für einen gegebenen Zeitraum zu bilden.

10. Herstellungsverfahren nach einem der Ansprüche 1-8, wobei der Schritt des Bildens des Unterfilms die Schritte umfasst:
Vorbereiten eines Substrats,
Zuführen eines V-Rohmaterialgases und eines III-Rohmaterialsgases auf das Substrat unter einem Druck von 27 hPa (20 Torr) oder darunter, um auf dem Substrat einen ersten Film, der aus einem III-Nitrid hergestellt ist, das 50 Atomprozent oder darüber an Al-Element für alle der III Elemente beinhaltet, durch das epitaxiale Wachstum für einen vorgegebenen Zeitraum zu bilden, und
Zuführen des V-Rohmaterialgases und des III-Rohmaterialgases auf das Substrat unter einem Druck von mehr als 27 hPa (20 Torr), um auf dem ersten Film einen zweiten Film, der aus einem weiteren III-Nitrid hergestellt ist, das 50 Atomprozent oder darüber an Al-Element für alle der III Elemente beinhaltet, durch das epitaxiale Wachstum für einen gegebenen Zeitraum zu bilden.

11. Herstellungsverfahren nach einem der Ansprüche 1-8, wobei der Schritt des Bildens des Unterfilms die Schritte umfasst:
Vorbereiten eines Substrats,
Zuführen eines V-Rohmaterialgases und eines III-Rohmaterialsgases auf das Substrat, das auf 1100 °C oder darüber erwärmt ist, um auf dem Substrat einen ersten Film, der aus einem III-Nitrid hergestellt ist, das 50 Atomprozent oder darüber an Al-Element für alle der III Elemente beinhaltet, durch das epitaxiale Wachstum für einen vorgegebenen Zeitraum zu bilden, und
Zuführen des V-Rohmaterialgases und des III-Rohmaterialgases auf das Substrat, das auf weniger als 1100 °C erwärmt ist, um auf dem ersten Film einen zweiten Film, der aus einem weiteren III-Nitrid hergestellt ist, das 50 Atomprozent oder darüber an Al-Element für alle der III Elemente beinhaltet, durch das epitaxiale Wachstum für einen gegebenen Zeitraum zu bilden.

## Revendications

1. Procédé de fabrication d'un film de nitrure de groupe III, comprenant les étapes consistant :
à préparer un substrat donné,
à former un sous-film dont la surface présente une structure concave-convexe dans laquelle 50% ou moins est occupée par une zone plate ayant une rugosité moyenne Ra inférieure ou égale à 10 Å et réalisé en un premier nitrure de groupe III comportant 50% en pourcentage atomique ou plus d'élément Al pour tous les éléments de groupe III constituant le premier nitrure de groupe III, et
à former un film de nitrure de groupe III sur le sous-film.

2. Procédé de fabrication tel que défini dans la revendication 1, dans lequel le premier nitrure de groupe III constituant le sous-film comporte 70% en pourcentage atomique ou plus d'élément Al pour tous les éléments de groupe III constituant le premier nitrure de groupe III.

3. Procédé de fabrication tel que défini dans la revendication 2, dans lequel le premier nitrure de groupe III constituant le sous-film est du AlN.

4. Procédé de fabrication tel que défini dans l'une quelconque des revendications 1-3, dans lequel 10% de la surface du sous-film est occupée par la zone plate.

5. Procédé de fabrication tel que défini dans l'une quelconque des revendications 1-4, dans lequel la structure concave-convexe, à l'exception de la zone plate de la surface du sous-film, comporte {101} des facettes.

6. Procédé de fabrication tel que défini dans l'une quelconque des revendications 1-5, dans lequel le substrat est réalisé en monocristal de saphir ou en monocristal de SiC.

7. Procédé de fabrication tel que défini dans la revendication 6, dans lequel un traitement de nitruration de surface est réalisé sur la surface principale du substrat en monocristal de saphir pour former une couche de surface nitrurée au niveau de la surface principale, et le sous-film est formé sur le substrat en monocristal de saphir par l'intermédiaire de la couche de surface nitrurée.

8. Procédé de fabrication tel que défini dans l'une quelconque des revendications 1-7, comprenant en outre l'étape consistant à former, sur le substrat, une couche de surface ayant une rugosité moyenne Ra inférieure ou égale à 10 Å, et réalisée en un deuxième nitrure de groupe III ayant une largeur à mi-hauteur dans une courbe de basculement de rayons X inférieure ou égale à 90 secondes et comportant 50% en pourcentage atomique ou plus d'élément Al pour tous les éléments de groupe III constituant le deuxième nitrure de groupe III.

9. Procédé de fabrication tel que défini dans l'une quelconque des revendications 1-8, dans lequel l'étape de formation du sous-film comprend les étapes consistant :
à préparer un substrat,
à fournir une matière première gazeuse de groupe V et une matière première gazeuse de groupe III sur le substrat à un rapport de débits (matière première gazeuse de groupe V/matière première gazeuse de groupe III) inférieur ou égal à 600, pour former, sur le substrat, un premier film réalisé en un nitrure de groupe III comportant 50% en pourcentage atomique ou plus d'élément Al pour tous les éléments de groupe III par la croissance épitaxiale pour une période donnée, et
à fournir la matière première gazeuse de groupe V et la matière première gazeuse de groupe III sur le substrat à un rapport de débits (matière première gazeuse de groupe V/matière première gazeuse de groupe III) supérieur à 600, pour former, sur le premier film, un deuxième film réalisé en un autre nitrure de groupe III comportant 50% en pourcentage atomique ou plus d'élément Al pour tous les éléments de groupe III par la croissance épitaxiale pour une période donnée.

10. Procédé de fabrication tel que défini dans l'une quelconque des revendications 1-8, dans lequel l'étape de formation du sous-film comprend les étapes consistant :
à préparer un substrat,
à fournir une matière première gazeuse de groupe V et une matière première gazeuse de groupe III sur le substrat sous une pression inférieure ou égale à 27hPa (20 Torr), pour former, sur le substrat, un premier film réalisé en un nitrure de groupe III comportant 50% en pourcentage atomique ou plus d'élément Al pour tous les éléments de groupe III par la croissance épitaxiale pour une période donnée, et
à fournir la matière première gazeuse de groupe V et la matière première gazeuse de groupe III sur le substrat sous une pression supérieure à 27 hPa (20 Torr), pour former, sur le premier film, un deuxième film réalisé en un autre nitrure de groupe III comportant 50% en pourcentage atomique ou plus d'élément Al pour tous les éléments de groupe III par la croissance épitaxiale pour une période donnée.

11. Procédé de fabrication tel que défini dans l'une quelconque des revendications 1-8, dans lequel l'étape de formation du sous-film comprend les étapes consistant :
à préparer un substrat,
à fournir une matière première gazeuse de groupe V et une matière première gazeuse de groupe III sur le substrat chauffé à une température supérieure ou égale à 1100°C, pour former, sur le substrat, un premier film réalisé en un nitrure de groupe III comportant 50% en pourcentage atomique ou plus d'élément Al pour tous les éléments de groupe III par la croissance épitaxiale pour une période donnée, et
à fournir la matière première gazeuse de groupe V et la matière première gazeuse de groupe III sur le substrat chauffé à une température inférieure à 1100°C, pour former, sur le premier film, un deuxième film réalisé en un autre nitrure de groupe III comportant 50% en pourcentage atomique ou plus d'élément Al pour tous les éléments de groupe III par la croissance épitaxiale pour une période donnée.
